(19) **Europäisches Patentamt**
**European Patent Office**
**Office européen des brevets**

(11) **EP 3 155 504 B1**

(12) **FASCICULE DE BREVET EUROPEEN**

(45) Date de publication et mention
de la délivrance du brevet:
**29.08.2018 Bulletin 2018/35**

(51) Int Cl.:
*G06F 3/041* *(2006.01)*      *G06F 3/044* *(2006.01)*
*G06F 1/16* *(2006.01)*

(21) Numéro de dépôt: **15727660.1**

(22) Date de dépôt: **09.06.2015**

(86) Numéro de dépôt international:
**PCT/EP2015/062763**

(87) Numéro de publication internationale:
**WO 2015/189167 (17.12.2015 Gazette 2015/50)**

(54) **PROCEDE, PRODUIT PROGRAMME D'ORDINATEUR ET DISPOSITIF POUR LOCALISER UNE INTERACTION SUR UNE SURFACE TACTILE**

VERFAHREN, COMPUTERPROGRAMMPRODUKT UND VORRICHTUNG ZUR ORTUNG VON INTERAKTION AUF EINER BERÜHRUNGSEMPFINDLICHEN OBERFLÄCHE

METHOD, COMPUTER PROGRAM PRODUCT AND DEVICE FOR LOCATING INTERACTION ON A TOUCH-SENSITIVE SURFACE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.06.2014 FR 1455302**

(43) Date de publication de la demande:
**19.04.2017 Bulletin 2017/16**

(73) Titulaire: **Commissariat à l'Énergie Atomique et aux Énergies Alternatives**
**75015 Paris (FR)**

(72) Inventeurs:
• **GUENARD, Nicolas**
  **F-78400 Chatou (FR)**

• **BOLZMACHER, Christian**
  **F-92120 Montrouge (FR)**
• **HAFEZ, Moustapha**
  **F-94110 Arcueil (FR)**

(74) Mandataire: **Lopez, Frédérique**
**Marks & Clerk France**
**Immeuble Visium**
**22 Avenue Aristide Briand**
**94117 Arcueil Cedex (FR)**

(56) Documents cités:
**US-A1- 2003 079 549      US-A1- 2007 113 681**

**Description**

**Domaine de l'invention**

L'invention est dans le domaine des surfaces tactiles et concerne plus particulièrement un procédé pour localiser une interaction sur une surface tactile.

**Etat de la Technique**

Pour rendre une surface de n'importe quelle nature tactile en permettant de localiser un appui sur une surface, les solutions connues relèvent principalement de deux approches, qui sont le déploiement d'un film capacitif ou la pose d'un cadre infrarouge sur la surface.

Dans les solutions basées sur l'utilisation d'un film capacitif, un film composé d'un réseau électrique gravé sur celui-ci et relié à une électronique est déployé et collé sur la surface à tactiliser. Lors d'un touché avec le doigt sur la surface, la capacité qui est mesurée est modifiée, permettant de localiser l'interaction. L'inconvénient de cette approche est qu'elle n'est pas compatible avec un autre élément que le doigt, rendant difficile par exemple le port de gants. De plus, le déploiement d'un tel film rend visible un réseau de fils imprimés sur celui-ci diminuant la transparence de la surface.

Les solutions basées sur la technologie infrarouge (IR) utilisent un cadre composé de diodes électroluminescentes (LEDs) infrarouges posé sur la surface et formant un quadrillage de rangées émettrices et réceptrices. Lorsqu'un doigt ou tout autre objet vient couper les faisceaux horizontaux et verticaux, il est localisé. Cette technologie est très sensible à la lumière du soleil qui est très chargée en infrarouge, ainsi qu'à l'environnement tel le niveau de saleté de la surface. De plus, le cadre infrarouge a en général l'aspect d'une cuvette, ce qui est un frein dans le design général et l'utilisation de surfaces diverses.

Un inconvénient supplémentaire commun aux approches connues, est le coût d'implémentation qui est très élevé et évolue de façon exponentielle en fonction de la taille de la surface à tactiliser.

Il existe par ailleurs d'autres technologies de tactilisation basées sur la mesure d'effort à partir de jauges de contraintes ou de capteurs de pression. Le point d'interaction est déterminé en considérant la répartition des efforts et en l'associant au barycentre des capteurs pondérés par les pressions respectives mesurées. Le brevet US3657475 propose un dispositif utilisant trois capteurs pour déterminer le point de pression sur une plaque. La demande de brevet US 2003/0079549 A1 présente une méthode pour localiser les points de pression sur une surface tactile qui est basée sur l'ajout d'une membrane flexible sur la surface tactile et de capteurs pour déterminer les points de pression sur la membrane.

Or, ces solutions sont applicables uniquement aux surfaces de petite taille, c'est-à-dire celles dont la taille n'excède pas celle des écrans conventionnels des ordinateurs personnels ou des tablettes.

Le passage à des surfaces plus importantes génère des problèmes quant à la rigidité de la plaque et à la déformation de la surface sous l'application d'une force d'interaction.

De plus, un manque de rigidité apparent d'une surface ne procure pas un bon ressenti pour l'utilisateur lors d'un touché.

Pour palier aux problèmes liés à la rigidité de la surface, il est possible d'augmenter le nombre de capteurs afin d'améliorer son maintien. Toutefois, l'utilisation de plus de quatre capteurs augmente le degré d'hyperstatisme du système et il n'est plus possible de déduire une équation analytique en appliquant le principe de la statique pour déterminer la localisation du touché.

Ainsi, il n'existe pas dans l'art antérieur, de solution adaptée à la localisation d'une interaction sur une surface de grande taille.

La présente invention répond à ce besoin en palliant aux inconvénients des approches existantes.

**Résumé de l'invention**

Un objet de la présente invention est de fournir un dispositif et un procédé permettant de localiser une interaction une surface de grande taille dont la rigidité est non infinie.

Avantageusement, le dispositif de l'invention permet qu'une surface de grande taille soit tactilisée de manière intégralement transparente.

Un autre objet de la présente invention est de fournir un procédé de tactilisation d'une surface offrant une mise en oeuvre aisée et un coût d'implémentation réduit.

Un autre objet de la présente invention est de proposer un dispositif de tactilisation modulaire permettant facilement l'ajout ou le retrait de capteurs.

Un autre objet de l'invention est de proposer un dispositif qui permet de limiter la déformation de la surface à tactiliser en permettant de la fixer sur un bâti encastrable.

Avantageusement, l'invention propose un procédé basé sur la mesure de force et la fusion d'informations issues de plusieurs capteurs pour localiser une interaction sur une surface à tactiliser.

La présente invention s'appliquera avantageusement pour des bornes interactives de grande taille, des meubles à tactiliser, ou encore toute application dite «simple touché» actuellement mise en oeuvre avec des dispositifs infrarouge et capacitif.

De part le faible coût du dispositif proposé, une application typique pourra être la tactilisation d'un plafonnier de grande taille dans l'habitacle d'une automobile. Le procédé et dispositif de la présente invention permet l'allumage total ou partiel du plafonnier via une interaction tactile localisée. Avantageusement, le dispositif proposé n'altère pas la transparence du plafonnier, et est particulièrement bien adapté pour laisser passer la lumière.

Pour obtenir les résultats recherchés, un procédé pour localiser une interaction sur une surface équipée d'une pluralité de capteurs positionnés selon des axes (X,Y) à des coordonnées (Xi,Yj), chaque capteur étant apte à fournir une valeur représentative de l'effort mesuré lors d'une interaction, est décrit. Le procédé comprend les étapes de :

(a) calculer pour chaque coordonnée Xi, une valeur représentative d'un effort pour un capteur équivalent, la valeur de chaque capteur équivalent correspondant à la somme des valeurs des capteurs positionnés sur la surface à ladite coordonnée Xi;

(b) utiliser la valeur de chaque capteur équivalent pour modéliser selon un critère de coût la répartition des efforts sur une pluralité de positions discrètes 'Li' de l'axe X, la pluralité de positions discrètes étant prédéfinies; et

(c) déterminer la position discrète 'Li' ayant le coût minimum, représentant la position la plus proche de l'interaction sur l'axe X.

Dans un mode de réalisation, les étapes (a) et (b) sont appliquées pour chaque coordonnée Yj de l'axe Y et pour une pluralité de positions discrètes 'Lj' et l'étape (c) détermine la position discrète 'Lj' la plus proche de l'interaction sur l'axe Y.

Avantageusement, le procédé comprend après l'étape de calcul (a), une étape de normaliser les valeurs de chaque capteur équivalent par rapport à des valeurs de modèles de capteurs de référence.

Dans un mode de réalisation, l'étape (b) de modélisation comprend les étapes de:

- calculer pour chaque position discrète 'Li' un coût de position individuel de chaque capteur équivalent; et
- calculer pour chaque position discrète 'Li', un coût de position général de capteur équivalent en fonction de la pluralité des coûts de position individuels.

Dans une variante, l'étape de calcul de coût individuel consiste à calculer la valeur au carré de l'écart entre la valeur normalisée du capteur équivalent et une valeur normalisée que ledit capteur équivalent mesurerait à ladite position discrète 'Li'.

Avantageusement, le procédé comprend une étape préliminaire de calibration permettant de définir la valeur normalisée.

Dans un mode de réalisation avantageux, le procédé comprend après l'étape (c) de détermination, une étape de filtrage des positions déterminées.

Avantageusement, le filtrage est fait avec un filtre passe bas. Dans une implémentation, la fréquence du filtre est définie selon des seuils réglables.

Le procédé de l'invention peut comprendre une étape préliminaire de détermination d'une interaction sur la surface. L'étape de détermination peut consister à mesurer un poids exercé sur la surface et à déterminer si le poids mesuré est supérieur à une valeur seuil. Avantageusement, une valeur de biais statique est retranchée de la mesure du poids exercé.

L'invention concerne aussi un dispositif pour localiser une interaction sur une surface équipée d'une pluralité de capteurs positionnés selon des axes (X,Y) à des coordonnées (Xi,Yj), chaque capteur étant apte à fournir une valeur représentative de l'effort mesuré lors d'une interaction, le dispositif comprenant des moyens pour mettre en oeuvre les étapes du procédé.

Avantageusement, la surface peut être encastrée dans un bâti fixe et la pluralité des capteurs peut comprendre des capteurs placés entre la surface et le bâti.

Dans une variante d'implémentation, la pluralité des capteurs peut comprendre des capteurs capacitifs plans positionnés sous la surface.

Alternativement, la pluralité des capteurs peut comprendre des capteurs capacitifs fourches, chaque capteur capacitif fourche comprenant deux capteurs capacitifs plans assemblés en un dispositif capacitif unitaire et positionnés respectivement en regard sur et sous ladite surface.

L'invention concerne également un produit programme d'ordinateur comprenant des instructions de code permettant d'effectuer les étapes du procédé.

Différents aspects et avantages de l'invention vont apparaître en appui de la description d'un mode préféré d'implémentation de l'invention mais non limitatif, avec référence aux figures ci-dessous.

## Description des figures

La figure 1 illustre un dispositif pour opérer le procédé de l'invention dans un mode de réalisation;

La figure 2 montre un exemple de capteur capacitif adapté pour opérer le procédé de l'invention;

La figure 3 illustre la relation entre un point d'interaction sur une surface et la position de capteurs.

La figure 4 montre un enchaînement des étapes du procédé de localisation d'une interaction dans un mode de réalisation;

La figure 5 détaille les étapes du calcul de l'estimation d'une position d'une interaction la plus proche dans un mode de réalisation ;

La figure 6 détaille les étapes du filtrage des résultats de l'étape d'estimation du procédé de la figure 5 ;

La figure 7 illustre une projection de capteurs en capteurs équivalents.

## Description détaillée de l'invention

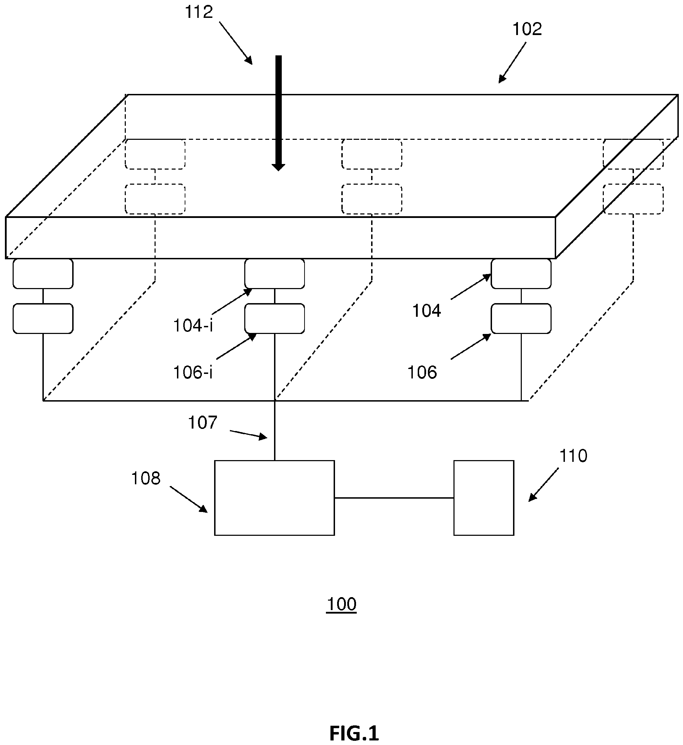

La figure 1 illustre un dispositif 100 pour opérer le procédé de l'invention dans un mode de réalisation. Dans l'exemple de la figure 1, une surface 102 est équipée d'une pluralité de capteurs 104-i. Pour des raisons de simplification de la description, la figure 1 montre six capteurs placés sous une surface rectangulaire, mais l'homme du métier pourra étendre les principes de l'invention à toute autre configuration de capteurs et autre forme de surface également surface en relief (3D). La surface peut être une plaque souple de polycarbonate ou une plaque thermoplastique transparente de Polyméthacrylate de méthyle (PMMA) ou être constituée de n'importe quel matériau de bois, de plastique ou de verre.

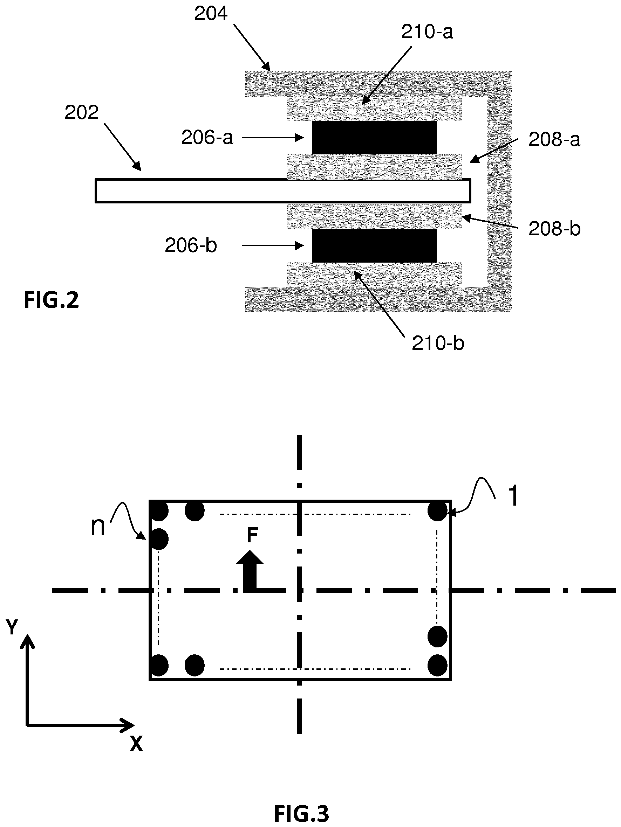

Dans un mode de réalisation, la surface peut être encastrée dans un support, un châssis ou un bâti fixe non montré sur la figure 1, et les capteurs placés entre la surface et le châssis. Dans une implémentation préférentielle, les capteurs sont un dispositif capacitif fourche tel que décrit en référence à la figure 2.

Avantageusement, afin de réduire les risques de parasitage liés aux sources externes et permettre la mesure d'un très faible changement de capacité, chaque capteur 104 est couplé localement à un module de mesure d'effort local 106 permettant de mesurer l'effort traversant le capteur lors d'une interaction 112 sur la surface. Dans une implémentation, le module de mesure d'effort contient des moyens de conversion analogique/numérique pouvant disposer d'un système de régulation ou de filtrage de l'alimentation.

La sortie de chaque module de mesure d'effort local 106 est envoyée à un module de localisation d'interaction 108 via un bus de transmission de données, de type bus de données série synchrone bidirectionnel half-duplex, comme le bus normalisé I2C par exemple. De manière préférentielle, les bus 107 assurant la liaison entre le module de localisation et chacun des modules de mesure d'effort de chaque capteur sont des fils blindés.

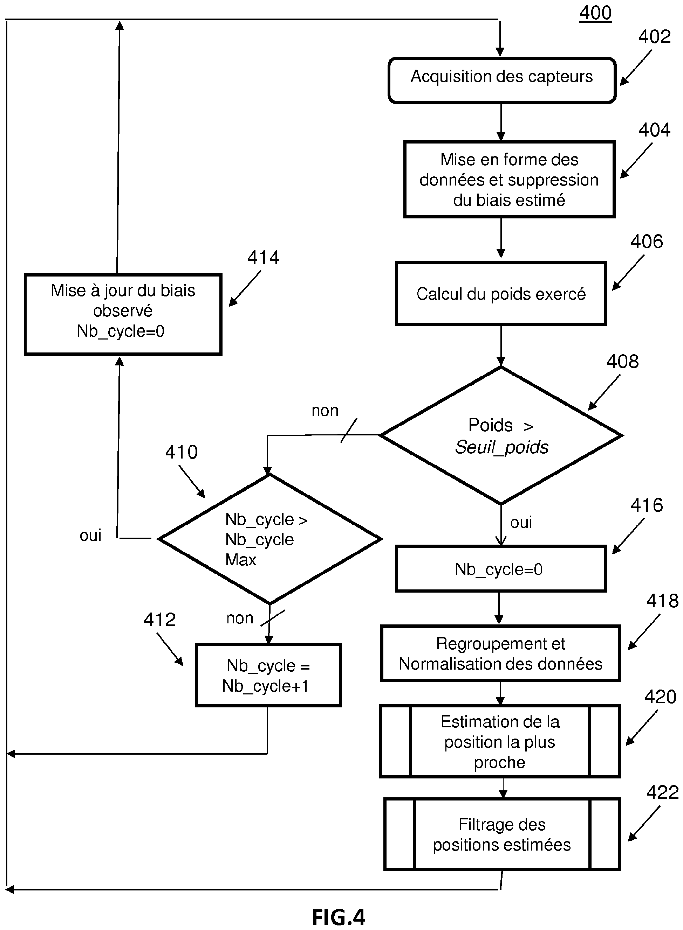

Les modules de mesure d'effort local 106-i sont couplés à un module de localisation d'interaction 108 apte à opérer le procédé de localisation de l'invention tel que décrit plus loin en référence aux figures 4 à 6.

De manière générale, le module de localisation d'interaction 108 comprend un multiplexer permettant de recevoir les données issues de la pluralité des modules de mesure d'effort 106-i, une unité de traitement de type microcontrôleur permettant d'exécuter le procédé de localisation d'interaction de l'invention, et divers composants permettant le filtrage et l'alimentation des fonctions. Par ailleurs, une connectique comportant alimentations, bus I2C et I/Os permet de venir connecter une extension.

Le microcontrôleur comprend de manière générale au moins un processeur, de la mémoire vive (RAM) et non volatile (FLASH) permettant de stocker et exécuter le procédé de localisation d'interaction de l'invention.

Dans une variante d'implémentation, un second module de localisation d'interaction peut opérer en mode 'esclave' avec un premier module maître permettant de répartir l'acquisition des données des capteurs sur les deux modules. Dans cette variante, une liaison de type I2C établit la communication entre les deux modules.

Avantageusement, l'arrangement électronique modulaire combinant les modules de mesure d'effort local 106-i et le module de localisation d'interaction 108 permet facilement l'ajout ou le retrait de capteurs 104-i afin de s'adapter à toute forme de surface et tout type d'application.

Le module de localisation d'interaction 108 peut être couplé à différents périphériques 110 permettant d'interpréter un résultat produit pour déclencher une action liée à la détection de l'interaction. Ainsi, le module peut par exemple être relié à un ordinateur via une sortie USB. Dans le contexte de l'invention, une action peut être une réponse selon la position d'une interaction, telle que par exemple, l'allumage d'une LED ou un bandeau de LEDs d'un plafonnier de voiture en fonction du côté sur lequel un appui a été exercé par un utilisateur.

La figure 2 illustra un exemple de capteur fourche dans une implémentation préférentielle de l'invention. Le capteur fourche est constitué de deux capteurs capacitifs assemblés en un dispositif capacitif unitaire, comprenant une armature centrale (208-a, 208-b) solidaire de l'une surface à tactiliser 202 et reliée à la masse, deux armatures externes (210-a, 210-b) reliées respectivement à une entrée du module de mesure d'effort local 106, les armatures externes étant respectivement séparées de l'armature centrale par un matériau diélectrique (206-a, 206-b).

Ainsi, les capteurs capacitifs sont situés respectivement de part et d'autre d'une plaque 202 présentant une face supérieure et une face inférieure. Dans le contexte de l'invention, le capteur situé au-dessus de la plaque est dit 'capteur supérieur' et le capteur situé au-dessous de la plaque est dit 'capteur inférieur'. Les capteurs sont disposés sur les bords de la plaque et encastrés dans un bâti ou châssis 204. Chaque capteur comprend deux électrodes séparées par un diélectrique (206-a, 206-b).

Le capteur supérieur comprend une première électrode 208-a solidaire de la plaque et une deuxième électrode 210-a solidaire du châssis. Un diélectrique 206-a constitué d'une matière élastique et isolante, comme par exemple du silicone ou du polyuréthane, est situé entre les deux électrodes. Le diélectrique permet d'augmenter la capacité mesurée en augmentant la permittivité du milieu. D'autre part, il constitue une fonction de rappel qui, lorsqu'une force liée à une interaction est appliquée sur la surface, se comprime pour rapprocher les deux électrodes, et qui, lorsque la force disparait, se détend afin de remettre les électrodes dans leur position initiale de repos.

De manière similaire, le capteur inférieur comprend une première électrode 208-b solidaire de la plaque et une deuxième électrode 210-b solidaire du châssis, séparées par un diélectrique 206-b.

Chaque électrode solidaire de la plaque est mobile sous l'effet d'une pression sur la plaque et de la déformation du diélectrique. Chaque électrode solidaire du bâti est fixe et constitue une électrode de signal reliée respectivement à une entrée du module de mesure d'effort local 106.

Dans une implémentation préférentielle, l'électrode de signal (210-a, 210-b) est constituée d'une plaque de forme cylindrique recouverte de cuivre sur chacune de ses faces. Une première face est reliée à un composant de conversion du module de mesure d'effort local 106. Le composant de conversion permet de convertir numériquement la capacité mesurée aux bornes du capteur. La seconde face de l'électrode de signal est reliée à un blindage pour éviter un éventuel parasitage. Dans les cas où le châssis est métallique, une seconde plaque de forme rectangulaire creusée permet d'isoler le blindage du châssis métallique afin d'éviter les courts-circuits et faire passer le fil blindé reliant l'ensemble des modules de mesure d'effort local au module de localisation 108.

D'autres procédés de mesure de la capacité permettant une mesure entre deux signaux différents de la masse peuvent être appliqués.

Dans une implémentation préférentielle, l'électrode mobile est constituée d'une plaque d'époxy reliée à la masse et collée à la surface 202 par un film adhésif qui peut être de l'ordre de 0,1 mm d'épaisseur. Pour les surfaces de grande taille, la rigidité de la plaque est importante et peut entrainer un angle de déviation de l'électrode de masse qui détériore la mesure. De façon optionnelle, une couche très souple comme de la mousse peut être insérée entre la surface 202 et l'armature centrale (208-a, 208-b) pour compenser l'angle de déviation lorsque la plaque se déforme.

Dans une implémentation particulière, la surface est une glace de 90 cm de longueur, de 3 mm d'épaisseur, équipée de six capteurs fourches dont les électrodes ont une aire d'environ 1cm$^2$. L'électrode de signal a une épaisseur de 1,6mm, l'électrode de masse a une épaisseur de 0,4mm, et le diélectrique inséré entre les deux électrodes est une mousse en polyéthylène de 0.8mm d'épaisseur.

Pris isolément, chaque capteur est un capteur capacitif plan dont la capacité mesurée est celle d'un condensateur plan qui s'exprime selon l'équation (1) suivante :

$$C = \varepsilon_a \, \frac{A}{d} \quad (1)$$

où $\varepsilon_a$ représente la permittivité du diélectrique, $A$ la surface des électrodes et $d$ la distance entre les deux électrodes. En notant $C_0$ la capacité initiale mesurée et $d = d_0$ la distance entre les deux électrodes lorsqu'aucune force n'est appliquée sur la surface, et en définissant $\Delta C = C - C_0$, on montre alors que :

$$\frac{\Delta C}{C_0} = \frac{d_0 - d}{d} \qquad (2)$$

et en posant $d = x.d_0$ tel que $0 < x \leq 1$, on obtient l'équation suivante :

$$\frac{\Delta C}{C_0} = \frac{1-x}{x} \qquad (3)$$

A partir de cette relation, une courbe d'évolution de l'écart relatif d'une capacité plan en fonction du pourcentage d'écrasement du diélectrique montre que pour avoir un $C_0$ suffisamment grand afin d'être correctement mesuré par des moyens de mesure par exemple de l'ordre de 10pF, et pour avoir la plus grande variation possible pour un petit déplacement de l'électrode mobile, la distance $d_0$ doit être minimum.

Il est aussi montré qu'afin d'avoir une force ou pression suffisamment grande pour un effort donné, la surface des électrodes $A$ doit être limitée. De plus, la déformation du diélectrique étant fonction du matériau choisi, il convient d'en tenir compte dans la relation réelle « effort appliqué/capacité mesurée ».

Ainsi avantageusement, le capteur fourche permet de cumuler l'effet d'un condensateur plan fonctionnant en compression, lorsqu'une force est appliquée sur la surface et que le capteur inférieur s'écrase, et d'un second condensateur plan fonctionnant en traction lorsqu'une force est appliquée sur la surface et que le capteur supérieur se dilate.

Avantageusement, le capteur fourche assemblé est de meilleur qualité que deux capteurs pris isolément par une augmentation de la dynamique de la mesure, un meilleur filtrage des perturbations, et un meilleur compromis sur la précision de la mesure. La fusion des capteurs inférieur et supérieur est réalisée au niveau du module de mesure d'effort local 106 reliant la capacité supérieure sur la borne positive et la capacité inférieure sur la borne négative et en calculant la somme des capacités mesurées sur chaque capteur.

De par sa configuration, avantageusement le capteur fourche permet l'encastrement dans un bâti et le maintien d'une surface à tactiliser sans qu'il soit nécessaire d'ajouter des moyens de fixation complémentaires. La demande de brevet du même déposant intitulée « Dispositif de maintien de surface tactile » déposée le même jour décrit un tel dispositif de maintien à base de capteur fourche.

Si la rigidité de la glace est insuffisante, le procédé de localisation d'interaction de l'invention peut être opéré pour un dispositif capacitif ne comportant qu'un seul capteur inférieur marchant en compression.

La figure 3 illustre la relation entre un point d'interaction sur une surface et la position de capteurs pour une surface de grande taille équipée de $N$ capteurs. Les capteurs sont disposés respectivement à un emplacement $Pos(n)$ de la plaque, où $n$ représente le numéro d'un capteur compris entre 1 et $N$. Les capteurs sont positionnés par rapport à des axes principaux (X, Y).

Afin de localiser l'interaction ayant lieu sur la surface, dans l'état de l'art, il est habituel d'assimiler la position $Pos(F)$ de l'interaction au barycentre de la position de tous les capteurs, pondérée par la force $\boldsymbol{C_n}$ mesurée par chacun d'eux, selon l'équation suivante :

$$\sum_n C_n . Pos(n) = F . Pos(F) \quad (4)$$

La position $Pos(n)$ des capteurs étant connue et $F = \sum_n C_n$, il est possible de déduire la position de la force F appliquée :

$$Pos(F) = \sum_n \frac{C_n}{F} . Pos(n) \quad (5)$$

En théorie, une telle relation est correcte, mais cependant elle ne prend pas en compte les diverses imperfections liées à des capteurs bon marché d'une part, tel le manque de précision ou la disparité entre les capteurs, et liées à la surface elle-même comme la rigidité limitée de la surface. Ainsi, en pratique il est constaté que la précision est insuffisante et qu'elle fluctue en fonction de la position de l'interaction sur la surface. Le procédé de l'invention permet de s'affranchir de ces inconvénients. Pour ce faire, le principe général du procédé 400 de localisation d'une interaction tel que décrit en référence à la figure 4 est basé sur la modélisation des répartitions d'efforts des capteurs et sur la minimisation d'un coût associé à la proximité des mesures des capteurs avec des modèles de référence qui sont établis en déplaçant une masse étalon à des positions connues de la surface.

Comme expliqué précédemment, l'utilisation de capteurs capacitifs permet de mesurer le déplacement d'une électrode soumise à une force de rappel, puis de la connaissance de ce déplacement, une image de la force appliquée sur l'électrode est déduite. Toutefois, la valeur à mesurer étant la force d'interaction pure entre l'utilisateur et la surface, il est important de compenser un biais statique, présent sur les capteurs, issu du poids de la plaque entre autre. Le biais statique est mesuré à l'initialisation du système à t=0, où le système est laissé libre, sans touché de l'utilisateur. Une capture des données issues des capteurs fourches est faite et fourni le biais statique.

Avantageusement, un moyennage sur plusieurs valeurs pendant quelques centaines de millisecondes permet d'améliorer la mesure. Dans la suite du procédé, le biais statique calculé est systématiquement retranché aux mesures effectuées lors des interactions.

Par ailleurs, la valeur renvoyée par un capteur peut être altérée par l'environnement, tel la température, l'humidité par exemple, et cette dérive constitue un biais dynamique variant dans le temps. De ce fait, la dérive occasionnée par le/les biais dynamiques est évaluée pour permettre de la compenser. Afin d'évaluer le biais dynamique, il est fait l'hypothèse que la dynamique de la perturbation est lente devant la fréquence d'échantillonnage du système et devant la dynamique d'interaction avec l'utilisateur, faisant dériver le système très lentement.

Après la phase d'initialisation, le procédé opéré par le module de localisation 108 débute lors d'une interaction, par une étape 402 d'acquisition des valeurs envoyées par les modules de mesures d'effort local 106-i de chaque capteur fourche.

Dans une étape suivante 404, les données reçues sont mises en forme pour déterminer une valeur courante du poids exercé, le biais statique est supprimé, et le poids exercé sur la surface est calculé (étape 406).

A l'étape suivante 408, le poids calculé (ôté du biais statique) est comparé à une valeur seuil *'Seuil_poids'*. De manière préférentielle, la valeur seuil est fixée et définie à la conception afin de réaliser un compromis entre la sensibilité de l'interaction désirée et les perturbations électrique et mécanique du système.

Si le poids calculé est supérieur à la valeur seuil, le procédé poursuit à l'étape 416 en considérant qu'une interaction est en train de se produire et que la déviation des capteurs est due à celle-ci.

Si le poids mesuré est inférieur à la valeur seuil, le procédé poursuit par les étapes 410, 412, 414 en considérant qu'il n'y a pas d'interaction avec un utilisateur, que la surface est supposée libre sans aucun touché et que les déviations résiduelles sont dues à des dérives assimilées au biais dynamique.

Afin de permettre au signal de monter lors des phases de transition de l'interaction, le critère de comparaison du poids mesuré à la valeur seuil doit se répéter durant n cycles (410, 412) avant la mise à jour du biais (414). Le nombre de n cycles nécessaires fixe la dynamique de perturbation.

Revenant à l'étape 416, signifiant qu'une interaction est détectée, le procédé de localisation poursuit de manière générale par les étapes 418, 420, 422 consistant en un regroupement et une normalisation des données regroupées (418), une estimation de la position la plus proche (420) et un filtrage des positions estimées (422).

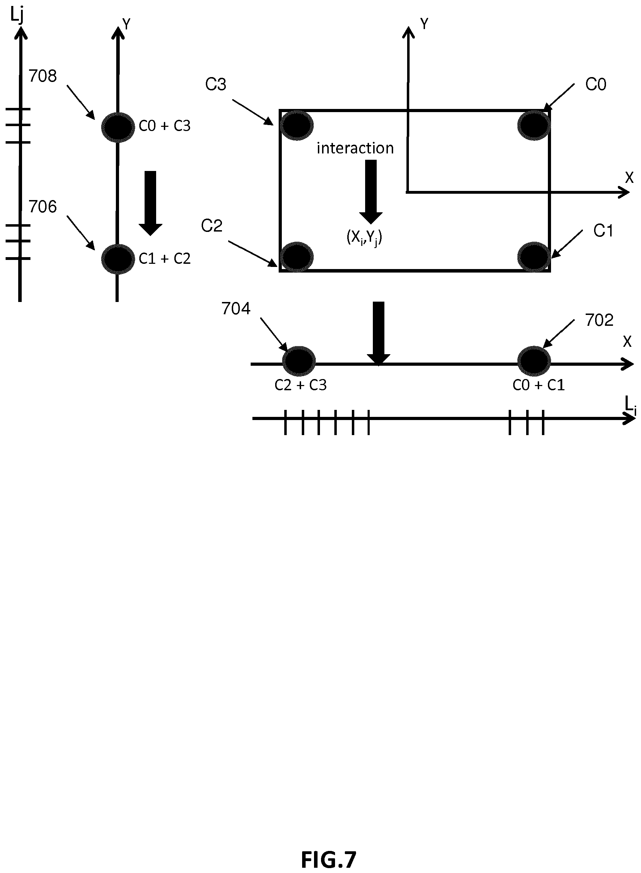

L'étape de regroupement 418 consiste à découpler les axes X et Y de la surface, puis à projeter sur chacun des axes les efforts mesurés par la pluralité des capteurs disposés sur de mêmes coordonnées sur l'axe perpendiculaire pour en déduire des capteurs dits « capteurs équivalents ». La Figure 7 illustre la projection de quatre capteurs (C0 à C3) disposés sur une surface en « capteur équivalent $C^o$ ». Ainsi l'exemple des capteurs de la figure 7 produit quatre capteurs équivalents. Un capteur équivalent a pour valeur, la somme des valeurs des capteurs projetés. Ainsi, un premier capteur équivalent (702) sur l'axe X qui est la projection des capteurs C0 et C1 a pour valeur la somme des valeurs mesurées sur les capteurs réels 'C0 + C1' situés en mêmes coordonnées. Un second capteur équivalent (704) sur l'axe X correspond à la projection des capteurs C2 et C3 et a pour valeur la somme 'C2+C3'. La projection sur l'axe Y des capteurs C1 et C2 produit un capteur équivalent (706) ayant une valeur égale à la somme 'C1+C2' des valeurs mesurées sur les capteurs C1 et C2. La projection sur l'axe Y des capteurs C0 et C3 produit un capteur équivalent (708) ayant une valeur égale à la somme 'C0+C3' des valeurs mesurées sur les capteurs C0 et C3.

L'exemple illustré n'est en rien limitatif et l'homme de l'art étendra le principe décrit quelque soit le nombre et les positions des capteurs.

La valeur de chaque capteur équivalent est ensuite normalisée « $C°_n$» afin de s'affranchir de la force de contact engendrée par l'interaction ainsi que de sa position sur la surface. Cette normalisation $C°_n$ est représentée dans l'équation (5) donnée plus haut comme étant le terme $\frac{C_n}{F}$ où $F = \sum C_n$.

Après l'étape 418 de regroupement et de normalisation des capteurs, le procédé poursuit à l'étape 420 par un calcul d'une estimation de la position la plus proche pour l'interaction.

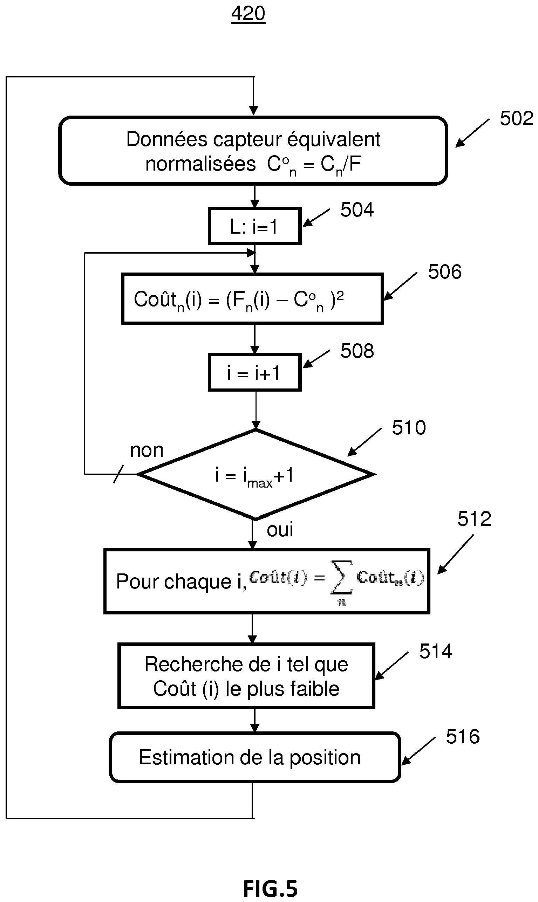

La figure 5 détaille cette étape du procédé dans un mode de réalisation. Après l'étape de récupération des données normalisées (502), le procédé consiste à discrétiser (504) un premier axe X en un ensemble de '*L*' positions possibles, *L* étant un nombre défini selon la précision voulue. En pratique, un ensemble de L=100 positions possibles permet d'atteindre une précision de l'ordre du centimètre pour une surface d'un mètre de long.

Le procédé entre ensuite dans une boucle de calcul (506, 508, 510) pour l'ensemble des positions définies. Le procédé permet de calculer, pour chacune des positions discrètes notée '$L_i$' et pour chaque capteur équivalent '*n*', l'écart entre la valeur normalisée du capteur équivalent 'C°ₙ' et une valeur normalisée 'Fₙ(i)' que ce capteur équivalent mesurerait s'il se trouvait à la position étudiée 'Lᵢ'. Cet écart est élevé au carré pour obtenir un coût de position noté :

$$\text{Coût}_n(i) = (F_n(i) - C^{\circ}_n)^2 \quad (6)$$

associé à la position 'Lᵢ'.

La valeur normalisée '$F_n(i)$' est préalablement définie lors d'une étape de calibration de la surface.

Le procédé incrémente les positions (508, 510) pour calculer un coût de position individuel associé à l'éligibilité d'une position 'i' pour chaque capteur équivalent.

Quand toutes les positions ont été prises en compte (branche Oui de 510), le procédé poursuit à l'étape 512, où un coût de position général est calculé pour chaque position '$L_i$', en sommant le coût individuel vu par chacun des capteurs équivalents, tel que :

$$Coût(i) = \sum_n \text{Coût}_n(i) \quad (7)$$

Puis à l'étape suivante 514, le procédé permet de déterminer la position discrète '$L_i$' sur l'axe considéré qui minimise le coût de position général. Puis le procédé génère à l'étape 516, la position sélectionnée, correspondant à la meilleure estimation de la position de l'interaction sur l'axe considéré.

Le procédé de l'étape 420 peut être répété pour le deuxième axe Y, pour les coordonnées $Y_j$ et pour des positions discrètes $L_j$.

Alternativement, le procédé décrit peut être appliqué seulement pour l'axe X et combiné avec une technique connue de calcul de barycentre pour le deuxième axe Y.

Avantageusement, le procédé de localisation de l'invention est robuste car il prend en compte l'ensemble des disparités du système par une étape initiale de calibration qui est réalisée à la mise en service, et qui peut aussi de manière simple être réinitialisée en cas de modification du système.

Ainsi, l'étape 420 produit les coordonnées $X_i$ et $Y_j$ de la position estimée la plus proche de l'interaction.

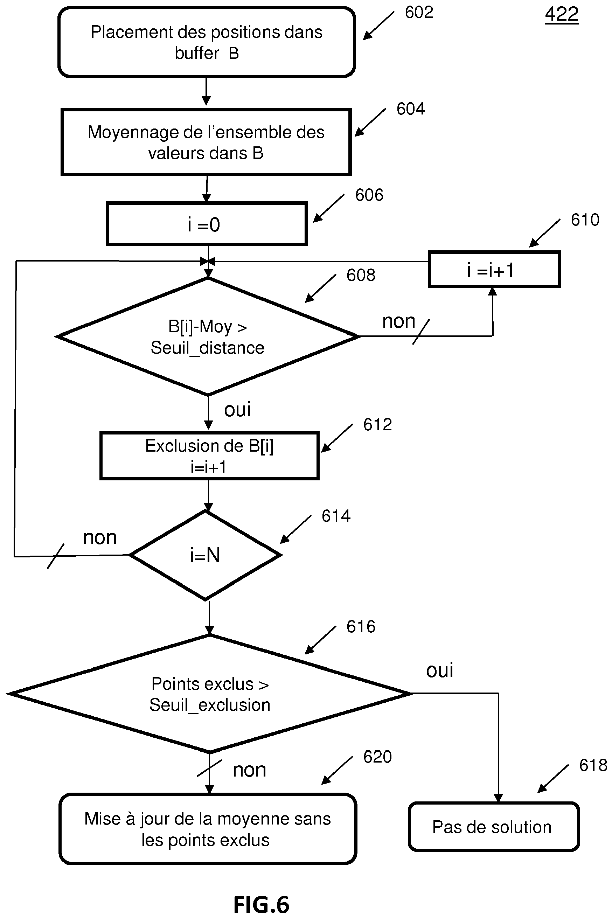

La position de l'interaction estimée en sortie de l'étape 420 peut ne pas être utilisée directement car elle peut être bruitée et parfois erronée notamment pendant les phases dynamiques du touché, ou par le manque de fiabilité notamment sur la dynamique des capteurs utilisés. De manière optionnelle, une étape de filtrage 422 peut être ajoutée au procédé, telle que décrite en référence à la figure 6. Un filtrage des mesures via un filtre passe bas est appliqué permettant d'éliminer les positions aberrantes. Des seuils réglables permettent de définir la fréquence de coupure du filtre ainsi que de durcir ou d'alléger le critère de rejet des points. Ces seuils sont réglés en fonction de deux principaux critères, la précision désirée et la fréquence de rafraîchissement.

Dans une première étape 602, les positions estimées sont placées dans un buffer tournant '$B$' de taille '*TailleBuff*' défini lors de la conception et une valeur de moyenne '*Moy*' est calculée (étape 604) pour l'ensemble des valeurs enregistrées.

Ensuite, le procédé permet (608) de calculer les distances entre les données placées dans le buffer et la moyenne 'B[i]-Moy', et de comparer l'écart à un seuil donné '*Seuil_distance*' fixe, réalisant un compromis entre la précision recherchée et la réactivité du système.

Si l'écart est inférieur au seuil, le procédé permet de conserver la valeur et passe à la valeur suivante (610).

Si l'écart est supérieur au seuil, la valeur concernée est exclue du buffer à l'étape 612, et le procédé traite une valeur suivante (614).

Quand toutes les valeurs du buffer ont été traitées, le procédé permet à l'étape suivante (616) de déterminer si le nombre de valeurs non exclues restants dans le buffer est suffisant et le compare à un seuil d'exclusion '*Seuil_exclusion*' fixe, réalisant un compromis entre la précision recherchée et la réactivité du système.

Si le nombre est insuffisant (618) car trop de valeurs ont été exclues, la précision suffisante n'est pas atteinte pour produire un résultat et il faudra attendre le prochain cycle pour disposer d'une sortie éventuelle.

Si le nombre est suffisant (620), la moyenne de l'ensemble des valeurs est mise à jour en ne prenant en compte que les points valides pour constituer la sortie filtrée du système.

On note alors que plus la taille du buffer '*B*' est grande et plus le lissage des données est important. De la même façon, plus le seuil de distance '*Seuil_distance*' est faible, moins l'algorithme est permissif sur l'éparpillement de la position estimée. Enfin, le seuil d'exclusion '*Seuil_exclusion*' sert principalement à garantir toujours une bande passante minimum du filtre passe bas, autrement dit un nombre de points suffisant dans le calcul de la moyenne.

Ainsi la présente description illustre une implémentation préférentielle de l'invention, mais n'est pas limitative. Elle peut s'implémenter à partir d'éléments matériel et/ou logiciel. Un exemple a été choisi pour permettre une bonne compréhension des principes de l'invention, mais il n'est en rien exhaustif et doit permettre à l'homme du métier d'apporter des modifications et variantes d'implémentation en conservant les mêmes principes.

**Revendications**

1. Un procédé pour localiser une interaction sur une surface équipée d'une pluralité de capteurs positionnés selon des axes (X,Y) à des coordonnées $(X_i,Y_j)$, chaque capteur étant apte à fournir une valeur représentative de l'effort mesuré lors d'une interaction, le procédé étant **caractérisé par** les étapes de :

   (a) calculer (502) pour chaque coordonnée $X_i$, une valeur représentative d'un effort pour un capteur équivalent, ladite valeur de chaque capteur équivalent correspondant à la somme des valeurs des capteurs positionnés sur la surface à ladite coordonnée $X_i$;
   (b) utiliser (506, 512) la valeur de chaque capteur équivalent pour modéliser la répartition des efforts sur une pluralité de positions discrètes prédéfinies '$L_i$' de l'axe X, la modélisation étant faite selon un critère de coût associé à la proximité des mesures des capteurs avec des modèles de référence établis en déplaçant une masse étalon à des positions connues de la surface; et
   (c) déterminer (514,516) la position discrète '$L_i$' ayant le coût minimum, représentant la position la plus proche de l'interaction sur l'axe X.

2. Le procédé selon la revendication 1 dans lequel les étapes (a) et (b) sont aussi appliquées pour chaque coordonnée $Y_j$ de l'axe Y et pour une pluralité de positions discrètes '$L_j$' et lequel l'étape (c) détermine la position discrète '$L_j$' la plus proche de l'interaction sur l'axe Y.

3. Le procédé selon la revendication 1 ou 2 comprenant après l'étape de calcul (a), une étape (418) de normaliser les valeurs de chaque capteur équivalent par rapport à des valeurs de modèles de capteurs de référence.

4. Le procédé selon l'une quelconque des revendications 1 à 3 dans lequel l'étape (b) de modélisation comprend les étapes de:

   - calculer (506) pour chaque position discrète '$L_i$' un coût de position individuel de chaque capteur équivalent; et
   - calculer (512) pour chaque position discrète '$L_i$', un coût de position général de capteur équivalent en fonction de la pluralité des coûts de position individuels.

5. Le procédé selon la revendication 4 dans lequel l'étape de calcul de coût individuel consiste à calculer la valeur au carré de l'écart entre la valeur normalisée du capteur équivalent et une valeur normalisée que ledit capteur équivalent mesurerait à ladite position discrète '$L_i$'.

6. Le procédé selon la revendication 5 comprenant une étape préliminaire de calibration permettant de définir la valeur normalisée.

7. Le procédé selon l'une quelconque des revendications 1 à 6 comprenant de plus après l'étape (c) une étape (422) de filtrage des positions déterminées.

8. Le procédé selon la revendication 7 dans lequel le filtrage est fait avec un filtre passe bas.

9. Le procédé selon la revendication 8 dans lequel la fréquence du filtre est définie selon des seuils réglables.

10. Le procédé selon l'une quelconque des revendications 1 à 9 comprenant de plus avant l'étape (a), une étape (402, 404, 406, 408) de détermination d'une interaction sur la surface.

11. Le procédé selon la revendication 10 dans lequel l'étape de détermination d'une interaction consiste à mesurer (406) un poids exercé sur la surface et à déterminer (408) si le poids mesuré est supérieur à une valeur seuil.

12. Le procédé selon la revendication 11 dans lequel une valeur de biais statique est retranchée (404) de la mesure du poids exercé.

13. Un produit programme d'ordinateur, ledit programme d'ordinateur comprenant des instructions de code permettant d'effectuer les étapes du procédé selon l'une quelconque des revendications 1 à 12, lorsque ledit programme est exécuté sur un ordinateur.

14. Un dispositif pour localiser une interaction sur une surface équipée d'une pluralité de capteurs (104_i, 106-i) positionnés selon des axes (X,Y) à des coordonnées $(X_i,Y_j)$, chaque capteur étant apte à fournir une valeur représentative de l'effort mesuré lors d'une interaction, le dispositif comprenant des moyens pour mettre en oeuvre les étapes du procédé selon l'une quelconque des revendications 1 à 12.

15. Le dispositif selon la revendication 14 dans lequel la surface (202) est encastrée dans un bâti fixe (204) et la pluralité des capteurs comprend des capteurs (210-a, 210-b) placés entre la surface et le bâti.

16. Le dispositif selon la revendication 14 ou 15 dans lequel la pluralité des capteurs comprend des capteurs capacitifs plans positionnés sous ladite surface.

17. Le dispositif selon l'une quelconque des revendications 14 à 16 dans lequel la pluralité des capteurs comprend des capteurs capacitifs fourches, chaque capteur capacitif fourche comprenant deux capteurs capacitifs plans assemblés en un dispositif capacitif unitaire et positionnés respectivement en regard sur et sous ladite surface.

**Patentansprüche**

1. Verfahren zum Orten einer Interaktion auf einer Oberfläche, die mit einer Vielzahl von Sensoren ausgestattet sind, die entlang Achsen (X, Y) mit den Koordinaten $(X_i, Y_j)$ positioniert sind, wobei jeder Sensor einen Wert liefern kann, der die bei einer Interaktion gemessene Kraft repräsentiert, wobei das Verfahren durch die folgenden Schritte gekennzeichnet ist:

a) Berechnen (502), für jede Koordinate $X_i$, eines Wertes, der eine Kraft für einen äquivalenten Sensor repräsentiert, wobei der Wert jedes äquivalenten Sensors der Summe der Werte der auf der Oberfläche auf der Koordinate $X_i$ positionierten Sensoren entspricht;

b) Nutzen (506, 512) des Wertes jedes äquivalenten Sensors zum Modellieren der Verteilung der Kräfte auf mehrere vordefinierte diskrete Positionen 'L$_i$' der X-Achse, wobei die Modellierung gemäß einem mit der Nähe der Messungen der Sensoren assoziierten Kostenkriterium mit den Referenzmodellen erfolgt, die durch Bewegen einer Prüfmasse zu bekannten Positionen der Oberfläche aufgestellt werden; und

c) Bestimmen (514, 516) der diskreten Position 'L$_i$' mit den geringsten Kosten, die die nächstliegende Position der Interaktion auf der X-Achse repräsentiert.

2. Verfahren nach Anspruch 1, bei dem die Schritte a) und b) auch für jede Koordinate $Y_j$ der Y-Achse und für mehrere diskrete Positionen 'L$_j$' angewendet werden und bei dem Schritt c) die nächstliegende diskrete Position 'L$_j$' der Interaktion auf der Y-Achse bestimmt.

3. Verfahren nach Anspruch 1 oder 2, das nach dem Rechenschritt a) einen Schritt (418) des Normalisierens der Werte jedes äquivalenten Sensors mit Bezug auf die Modellwerte von Referenzsensoren beinhaltet.

4. Verfahren nach einem der Ansprüche 1 bis 3, bei dem der Modellierungsschritt b) die folgenden Schritte beinhaltet:

- Berechnen (506), für jede diskrete Position 'L$_i$', von individuellen Positionskosten jedes äquivalenten Sensors; und
- Berechnen (512), für jede diskrete Position 'L$_i$', von allgemeinen Positionskosten des äquivalenten Sensors in Abhängigkeit von den mehreren individuellen Positionskosten.

5. Verfahren nach Anspruch 4, bei dem der Schritt des Berechnens von individuellen Kosten im Berechnen des Quadratwertes des Abstands zwischen dem normalisierten Wert des äquivalenten Sensors und einem normalisierten Wert besteht, den der äquivalente Sensor an der diskreten Position 'L$_i$' messen würde.

6. Verfahren nach Anspruch 5, das einen vorläufigen Kalibrationsschritt beinhaltet, der das Definieren des normalisierten Wertes zulässt.

7. Verfahren nach einem der Ansprüche 1 bis 6, das ferner nach Schritt c) einen Schritt (422) des Filterns der bestimmten Positionen beinhaltet.

8. Verfahren nach Anspruch 7, bei dem das Filtern mit einem Tiefpassfilter erfolgt.

9. Verfahren nach Anspruch 8, bei dem die Frequenz des Filters gemäß regelbaren Schwellen definiert wird.

10. Verfahren nach einem der Ansprüche 1 bis 9, das ferner vor Schritt a) einen Schritt (402, 404, 406, 408) des Bestimmens einer Interaktion auf der Oberfläche beinhaltet.

11. Verfahren nach Anspruch 10, bei dem der Schritt des Bestimmens einer Interaktion im Messen (406) eines auf die Oberfläche aufgebrachten Gewichts und im Bestimmen (408) besteht, ob das gemessene Gewicht größer ist als ein Schwellenwert.

12. Verfahren nach Anspruch 11, bei dem eine statischer Verzerrungswert vom Messwert des aufgebrachten Gewichts subtrahiert (404) wird.

13. Computerprogrammprodukt, wobei das Computerprogramm Code-Befehle umfasst, die es zulassen, die Schritte des Verfahrens nach einem der Ansprüche 1 bis 12 durchzuführen, wenn das Programm auf einem Computer ausgeführt wird.

14. Vorrichtung zum Orten einer Interaktion auf einer Oberfläche, die mit einer Vielzahl von Sensoren (104_i, 106-i) ausgestattet ist, die entlang Achsen (X, Y) bei den Koordinaten $(X_i, Y_j)$ positioniert sind, wobei jeder Sensor einen Wert liefern kann, der die bei einer Interaktion gemessene Kraft repräsentiert, wobei die Vorrichtung Mittel zum Durchführen der Schritte des Verfahrens nach einem der Ansprüche 1 bis 12 umfasst.

15. Vorrichtung nach Anspruch 14, bei der die Oberfläche (202) in einem festen Gehäuse (204) eingeschlossen ist und die Vielzahl von Sensoren (210-a, 210-b) umfassen, die zwischen der Oberfläche und dem Gehäuse platziert sind.

16. Vorrichtung nach Anspruch 14 oder 15, bei der die Vielzahl von Sensoren ebene kapazitive Sensoren umfasst, die unter der Oberfläche positioniert sind.

17. Vorrichtung nach einem der Ansprüche 14 bis 16, bei der die Vielzahl von Sensoren gegabelte kapazitive Sensoren umfasst, wobei jeder gegabelte kapazitive Sensor zwei ebene kapazitive Sensoren umfasst, die zu einer einheitlichen kapazitiven Vorrichtung zusammengefügt und jeweils einander gegenüber auf und unter der Oberfläche positioniert sind.

**Claims**

1. A method for locating an interaction on a surface equipped with a plurality of sensors positioned according to axes (X, Y) at coordinates $(X_i, Y_j)$, each sensor being capable of providing a value representative of the load measured during an interaction, the method comprising the steps of:

(a) calculating (502) for each coordinate X;, a value representative of a load for an equivalent sensor, said value of each equivalent sensor corresponding to the sum of the values of the sensors positioned on the surface at said coordinate $X_i$;
(b) using (506, 512) the value of each equivalent sensor for modelling the distribution of loads on a plurality of predefined discrete positions '$L_i$' of the X axis, the modelling being made according to a cost criterion associated with the proximity of the measurements of the sensors with established reference models by moving a gauge mass to known positions of the surface; and
(c) determining (514, 516) the discrete position '$L_i$' having the minimum cost, representing the position closest to the interaction on the X axis.

2. Method according to claim 1 wherein steps (a) and (b) are also applied for each coordinate $Y_j$ of the Y axis and for a plurality of discrete positions '$L_j$' and in which step (c) determines the discrete position '$L_j$' closest to the interaction on the Y axis.

3. Method according to claim 1 or 2 further comprising after the step of calculating (a), a step (418) of normalising the values of each equivalent sensor relative to model values of the reference sensors.

4. Method according to any one of claims 1 to 3 wherein the step (b) of modelling comprises the steps of:

  - calculating (506) for each discrete position 'L$_i$' an individual position cost of each equivalent sensor; and
  - calculating (512) for each discrete position 'L$_i$', a general position cost of equivalent sensor based on the plurality of individual position costs.

5. Method according to claim 4 wherein the step of calculating the individual cost consists of calculating the squared value of the difference between the normalised value of the equivalent sensor and a normalised value that said equivalent sensor would measure at said discrete position 'L$_i$'.

6. Method according to claim 5 further comprising a preliminary calibration step for defining the normalised value.

7. Method according to any one of claims 1 to 6 further comprising after step (c) a step (422) of filtering the determined positions.

8. Method according to claim 7 wherein the filtering is done with a low-pass filter.

9. Method according to claim 8 wherein the frequency of the filter is defined according to adjustable thresholds.

10. Method according to any one of claims 1 to 9 further comprising before step (a), a step (402, 404, 406, 408) of determining an interaction on the surface.

11. Method according to claim 10 wherein the step of determining an interaction consists of measuring (406) weight exerted on the surface and determining (408) whether the measured weight is larger than a threshold value.

12. Method according to claim 11 wherein a static bias value is subtracted (404) from the measurement of the exerted weight.

13. A computer program product, said computer program comprising code instructions for carrying out the steps of the method according to any one of claims 1 to 12, when said program is executed on a computer.

14. A device for locating an interaction on a surface equipped with a plurality of sensors (104_i, 106-i) positioned about axes (X,Y) at coordinates (X$_i$, Y$_j$), each sensor being capable of providing a value representative of the load measured during an interaction, the device comprising means for implementing the steps of the method according to any one of claims 1 to 12.

15. Device according to claim 14 wherein the surface (202) is embedded in a fixed mount (204) and the plurality of sensors comprises the sensors (210-a, 210-b) placed between the surface and the mount.

16. Device according to claim 14 or 15 wherein the plurality of sensors comprises plane capacitive sensors positioned underneath said surface.

17. Device according to any one of claims 14 to 16 wherein the plurality of sensors comprises fork capacitive sensors, each fork capacitive sensor comprising two plane capacitive sensors assembled in a unitary capacitive device and positioned respectively facing above and below said surface.

**FIG.1**

204

210-a

202

206-a

208-a

208-b

206-b

210-b

**FIG.2**

n

1

F

Y

X

**FIG.3**

400

Acquisition des capteurs 402

Mise en forme des données et suppression du biais estimé 404

Calcul du poids exercé 406

Poids > *Seuil_poids* 408

non

oui

Nb_cycle > Nb_cycle Max 410

oui

non

Nb_cycle = Nb_cycle+1 412

Mise à jour du biais observé Nb_cycle=0 414

Nb_cycle=0 416

Regroupement et Normalisation des données 418

Estimation de la position la plus proche 420

Filtrage des positions estimées 422

**FIG.4**

420

Données capteur équivalent normalisées $C^{\circ}_{n} = C_{n}/F$ — 502

L: i=1 — 504

$Coût_{n}(i) = (F_{n}(i) - C^{\circ}_{n})^2$ — 506

i = i+1 — 508

non

i = i_{max}+1 — 510

oui

Pour chaque i, $Coût(i) = \sum_{n} Coût_{n}(i)$ — 512

Recherche de i tel que Coût (i) le plus faible — 514

Estimation de la position — 516

**FIG.5**

422

Placement des positions dans buffer B — 602

Moyennage de l'ensemble des valeurs dans B — 604

i = 0 — 606

i = i+1 — 610

B[i]-Moy > Seuil_distance — 608

non

oui

Exclusion de B[i] i=i+1 — 612

i=N — 614

non

Points exclus > Seuil_exclusion — 616

oui

non

Mise à jour de la moyenne sans les points exclus — 620

Pas de solution — 618

**FIG.6**

FIG.7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 3657475 A

- US 20030079549 A1